# EUROPÄISCHE PATENTSCHRIFT

(11) **EP 3 602 624 B1**
(45) Veröffentlichungstag und Bekanntmachung des Hinweises auf die Patenterteilung: **26.11.2025**
(21) Anmeldenummer: 17713209.9
(22) Anmeldetag: 20.03.2017
(51) Int. Cl.: H01L 23/544, H01L 21/68, H01L 21/60, H01L 21/67, H01L 23/00

(54) **VERFAHREN ZUR AUSRICHTUNG ZWEIER SUBSTRATE**
METHOD FOR ALIGNING TWO SUBSTRATES
PROCÉDÉ POUR ALIGNER DEUX SUBSTRATS

(43) Veröffentlichungstag der Anmeldung: 05.02.2020
(73) Patentinhaber: EV Group E. Thallner GmbH, St. Florian am Inn (AT)
(72) Erfinder: WAGENLEITNER, Thomas, 4971 Aurolzmünster (AT)
(74) Vertreter: Schneider, Sascha
(86) Internationale Anmeldenummer: PCT/EP2017/056584
(87) Internationale Veröffentlichungsnummer: WO 2018/171861

(56) Entgegenhaltungen:
- WO-A1-2010/023935
- US-A1- 2012 255 365
- US-A1- 2015 083 786
- MATTHIAS T ET AL: "Aligned wafer bonding for 3D interconnect and wafer-level layer transfer processes", PROCEEDINGS / 2005 INTERNATIONAL SYMPOSIUM ON MICROELECTRONICS : SEPTEMBER 25 - 29, 2005, PENNSYLVANIA CONVENTION CENTER, PHILADELPHIA,, 25 September 2005 (2005-09-25), pages 6 - 16, XP009185885, ISBN: 978-0-930815-77-6

## Beschreibung

Substrate werden gemäß dem Stand der Technik mit Hilfe von Ausrichtungsanlagen zueinander orientiert. Auf den Substraten befinden sich Ausrichtungsmarken, die durch die Ausrichtungsanlagen zueinander ausgerichtet werden. Der Stand der Technik kennt unzählige Verfahren zur Vermessung der Ausrichtungsmarken, zur korrekten Positionierung der Substrate auf denen sich die Ausrichtungsmarken befinden sowie zum darauffolgenden Bondschritt.

Druckschrift WO 2010/023935 A1 offenbart eine Vorrichtung zum Ausrichten von Substraten, wobei eine Haltefläche in der Oberflächenrichtung eines Substrats verschoben wird, während eines von einem Paar einander gegenüberliegender Substrate gehalten wird.

Das größte Problem bei der Vermessung von Ausrichtungsmarken besteht darin, dass die Ausrichtungsmarken selbst niemals perfekt sind. Sie sind verzerrt, besitzen eine rauhe Oberfläche, schlecht hergestellte Kanten etc. Sehr oft ist der Kontrast oder optische Effekte maßgeblich dafür verantwortlich, dass die Optiken und die Kameras nicht in der Lage sind, ein optimales Bild der Ausrichtungsmarke zu erhalten. Da die Ausrichtungsmarken durch eine Software erkannt und vermessen werden, ist die Genauigkeit der Positionsbestimmung der Ausrichtungsmarke maßgeblich von deren Qualität abhängig. Die Qualität der Ausrichtungsmarke kann allerdings nicht beliebig erhöht werden, sodass man immer davon ausgehen muss, nicht perfekte Ausrichtungsmarken zu vermessen.

Ein weiteres Problem im Stand der Technik besteht darin, dass es minimale Abweichungen von der Soll-Position der Ausrichtungsmarken geben kann. Im Computer werden die Positionen der Ausrichtungsmarken zwar mit größtmöglicher Genauigkeit definiert, die Herstellung der Ausrichtungsmarken ist aber durch die Genauigkeit der Prozesse und Anlagen beschränkt, welche die Ausrichtungsmarken auf der Substratoberfläche erzeugen. Selbst wenn die Ausrichtungsmarken keine Abweichung von ihrer idealen Geometrie aufweisen würden, kann deren reale Position minimal von der idealen Position abweichen. Die Ausrichtungsmarkenabweichung liegt ungefähr zwischen 1-100 nm, also im Nanometerbereich.

Es ist daher die Aufgabe der vorliegenden Erfindung, ein Verfahren anzugeben, mit dem die Genauigkeit der Ausrichtung zweier Substrate zueinander verbessert werden kann.

Diese Aufgabe wird mit den Merkmalen der nebengeordneten Patentansprüche gelöst. Vorteilhafte Weiterbildungen der Erfindung sind in den Unteransprüchen angegeben. Bei Wertebereichen sollen auch innerhalb der genannten Grenzen liegende Werte als Grenzwerte offenbart und in beliebiger Kombination beanspruchbar sein.

Vorgeschlagen wird ein Verfahren zur Ausrichtung zweier zu bondender Substrate, wobei unter anderem das erste Substrat eine erste Substratoberfläche mit einer ersten Substratoberflächenseite (im Folgenden auch als linke Substratoberflächenseite bezeichnet) und einer der ersten Substratoberflächenseite gegenüberliegenden zweiten Substratoberflächenseite (im Folgenden auch als rechte Substratoberflächenseite bezeichnet) aufweist, wobei das zweite Substrat eine mit der ersten Substratoberfläche zu bondende zweite Substratoberfläche aufweist, wobei die zweite Substratoberfläche eine dritte Substratoberflächenseite (im Folgenden auch als linke Substratoberflächenseite bezeichnet) und eine der dritten Substratoberflächenseite (im Folgenden auch als rechte Substratoberflächenseite bezeichnet) gegenüberliegende vierte Substratoberflächenseite aufweist, wobei das Verfahren mindestens die folgenden Schritte aufweist:
-- Erfassung und Speicherung von ersten Positionen eines ersten Ausrichtungsmarkenpaares auf der ersten Substratoberfläche des ersten Substrats, wobei eine erste Ausrichtungsmarke des ersten Ausrichtungsmarkenpaares auf der ersten Substratoberflächenseite angeordnet ist und eine zweite Ausrichtungsmarke des ersten Ausrichtungsmarkenpaares auf der zweiten Substratoberflächenseite angeordnet ist,
-- Erfassung und Speicherung von zweiten Positionen eines zweiten Ausrichtungsmarkenpaares auf der zweiten Substratoberfläche des zweiten Substrats, wobei eine dritte Ausrichtungsmarke des zweiten Ausrichtungsmarkenpaares auf der dritten Substratoberflächenseite angeordnet ist und eine vierte Ausrichtungsmarke des zweiten Ausrichtungsmarkenpaares auf der vierten Substratoberflächenseite angeordnet ist,
-- Erfassung und Speicherung von dritten Positionen eines dritten Ausrichtungsmarkenpaares auf der zweiten Substratoberfläche des zweiten Substrats, wobei eine fünfte Ausrichtungsmarke des dritten Ausrichtungsmarkenpaares auf der dritten Substratoberflächenseite angeordnet ist und eine sechste Ausrichtungsmarke des dritten Ausrichtungsmarkenpaares auf der vierten Substratoberflächenseite angeordnet ist,
-- Erfassung und Speicherung von vierten Positionen eines vierten Ausrichtungsmarkenpaares auf dem ersten Substrat, wobei eine siebte Ausrichtungsmarke des vierten Ausrichtungsmarkenpaares auf der ersten Substratoberflächenseite angeordnet ist und eine achte Ausrichtungsmarke des vierten Ausrichtungsmarkenpaares auf der zweiten Substratoberflächenseite angeordnet ist,
-- Ausrichtung der beiden Substrate zueinander in Abhängigkeit der erfassten ersten Positionen, zweiten Positionen, dritten Positionen und vierten Positionen.

Bevorzugt weist das Verfahren die folgenden Schritte, insbesondere den folgenden Ablauf auf:
-- Anordnung und Fixierung der Substrate auf Substrathaltern,
-- Bewegen des ersten Substrathalters mit dem ersten Substrat in eine erste Erfassungsposition,
-- Erfassung und Speicherung der ersten Positionen des ersten Ausrichtungsmarkenpaares auf der ersten Substratoberfläche des ersten Substrats in der ersten Erfassungsposition, wobei die erste Ausrichtungsmarke des ersten Ausrichtungsmarkenpaares auf der ersten Substratoberflächenseite angeordnet ist und die zweite Ausrichtungsmarke des ersten Ausrichtungsmarkenpaares auf der zweiten Substratoberflächenseite angeordnet ist,
-- Bewegen des zweiten Substrathalters mit dem zweiten Substrat in eine zweite Erfassungsposition und, insbesondere gleichzeitige, Bewegung des ersten Substrathalters mit dem ersten Substrat in eine erste Warteposition,
-- Erfassung und Speicherung der zweiten Positionen des zweiten Ausrichtungsmarkenpaares auf der zweiten Substratoberfläche des zweiten Substrats in der zweiten Erfassungsposition, wobei die dritte Ausrichtungsmarke des zweiten Ausrichtungsmarkenpaares auf der dritten Substratoberflächenseite angeordnet ist und die vierte Ausrichtungsmarke des zweiten Ausrichtungsmarkenpaares auf der vierten Substratoberflächenseite angeordnet ist,
-- Erfassung und Speicherung der dritten Positionen des dritten Ausrichtungsmarkenpaares auf der zweiten Substratoberfläche des zweiten Substrats in der zweiten Erfassungsposition des zweiten Substrathalters, wobei die fünfte Ausrichtungsmarke des dritten Ausrichtungsmarkenpaares auf der dritten Substratoberflächenseite angeordnet ist und die sechste Ausrichtungsmarke des dritten Ausrichtungsmarkenpaares auf der vierten Substratoberflächenseite angeordnet ist,
-- Bewegen des ersten Substrathalters mit dem ersten Substrat in die erste Erfassungsposition und, insbesondere gleichzeitige, Bewegung des zweiten Substrathalters mit dem zweiten Substrat in eine zweite Warteposition,
-- Erfassung und Speicherung der vierten Positionen des vierten Ausrichtungsmarkenpaares auf dem ersten Substrat in der ersten Erfassungsposition, wobei die siebte Ausrichtungsmarke des vierten Ausrichtungsmarkenpaares auf der ersten Substratoberflächenseite angeordnet ist und die achte Ausrichtungsmarke des vierten Ausrichtungsmarkenpaares auf der zweiten Substratoberflächenseite angeordnet ist,
-- Ausrichtung der beiden Substrate zueinander in Abhängigkeit der erfassten ersten Positionen, zweiten Positionen, dritten Positionen und vierten Positionen.

In einer bevorzugten Ausführungsform ist es vorgesehen, dass auf den Substraten pro Substratoberflächenseite die Positionen von mindestens drei Ausrichtungsmarken erfasst werden, bevorzugt von mindestens vier Ausrichtungsmarken, noch bevorzugter von mindestens fünf Ausrichtungsmarken, am bevorzugtesten von mindestens sechs Ausrichtungsmarken. Dadurch kann vorteilhaft die Genauigkeit der Ausrichtung verbessert werden.

In einer bevorzugten Ausführungsform ist es vorgesehen, dass die Ausrichtungsmarken einer Substratoberflächenseite innerhalb eines Kreises K mit einem Radius kleiner als 100 mm angeordnet sind, vorzugsweise kleiner als 50 mm, noch bevorzugter kleiner als 25mm, am bevorzugtesten kleiner als 10 mm, am allerbevorzugtesten kleiner als 1mm. Dadurch kann der Verfahrweg der Optik zur Detektion der Ausrichtungsmarken minimiert werden, sodass durch die Bewegung der Optik nur minimale Fehler entstehen. Vorzugsweise muss die Optik zur Detektion nicht bewegt werden.

Erfindungsgemäß befinden sich mehrere, insbesondere sogar alle, Ausrichtungsmarken derselben Substratoberflächenseite im Sichtbereich (engl.: field-of-view) einer Optik.

In einer noch bevorzugten erfindungsgemäßen Ausführungsform befinden sich mehrere, insbesondere alle, Ausrichtungsmarken derselben Substratoberflächenseite im Sichtbereich einer Optik, und sind zueinander zentriert. Dazu ist es notwendig, dass die Ausrichtungsmarken vom Zentrum nach außen immer größer werden und sich nicht überdecken.

In der erfindungsgemäßen Ausführungsformen, in der sich mehrere Ausrichtungsmarken im Sichtbereich der Optiken befinden, ist es von besonderem Interesse, dass sich die Ausrichtungsmarken möglichst weit am Rand des Substrats befinden um die Ausrichtungsgenauigkeit zu erhöhen. Die Ausrichtungsmarken befinden sich dann erfindungsgemäß weniger als 30 mm, vorzugsweise weniger als 20 mm, noch bevorzugter weniger als 10 mm, am bevorzugtesten weniger als 5 mm, am allerbevorzugtesten weniger als 11 mm vom Rand des Substrats entfernt.

Erfindungsgemäß ist es vorgesehen, dass die Positionen der Ausrichtungsmarken optisch erfasst werden. Dadurch ist vorteilhaft eine vergleichsweise genaue Positionsbestimmung möglich.

In einer bevorzugten Ausführungsform ist es vorgesehen, dass die Positionen der Substrathalter durch Interferometer und/oder Optiken erfasst werden, die insbesondere von Erfassungseinrichtungen zur Erfassung der Positionen der Ausrichtungsmarken unabhängig sind. Dadurch kann vorteilhaft die Positionsbestimmung der Substrathalter verbessert werden. Auch die Positionen der Optiken können durch Erfassungseinrichtungen, insbesondere durch Interferometer, bestimmt werden.

In einer bevorzugten Ausführungsform ist es vorgesehen, dass die Substrathalter in den Erfassungspositionen fixiert werden. Dadurch kann vorteilhaft die Position der Substrathalter besser ermittelt werden. Offenbart wird außerdem eine Vorrichtung zur Ausrichtung zweier zu bondender Substrate mit einem Verfahren, aufweisend:
-- Substrathalter zur Aufnahme und Fixierung der Substrate,
-- Bewegungseinrichtungen zur Bewegung der Substrathalter,
-- Optiken zur Erfassung von Positionen von Ausrichtungsmarken auf den Substraten,
-- eine Speichereinrichtung zur Speicherung der Positionen der Ausrichtungsmarken.

Die Merkmale zum Verfahren beziehen sich sinngemäß auch auf die Vorrichtung.

Die vorliegende Offenlegung betrifft außerdem ein Produkt mit zwei Substraten, aufweisend auf jeder Seite mindestens zwei Ausrichtungsmarken, wobei dieses Produkt nicht Teil des beanspruchten Gegenstands ist.

Der Kern der Erfindung besteht insbesondere darin, ein statistisches Verfahren aufzuzeigen, mit dessen Hilfe man zwei Substrate in Bezug zu deren Ausrichtungsmarken verbessert ausrichten und miteinander bonden kann, indem man auf eine Ermittlung mehrerer Ausrichtungsmarken zurückgreift, die sich an verschiedenen Positionen befinden, insbesondere in unterschiedlichem radialen Abstand zum Zentrum des Substrats. Das Problem der Substratausrichtung wird insbesondere dadurch verbessert, dass man nicht die Ausrichtungsmarken an sich, sondern statistisch gemittelte Positionen, die sich aus mehreren Ausrichtungsmarken berechnen lassen, zur Ausrichtung der Substrate zueinander verwendet.

Die Erfindung erlaubt vorteilhaft die Ausrichtung zweier Substrate mit einer erhöhten Präzession auch dann, wenn die Ausrichtungsmarken nicht in Bezug auf Ihre Form und/oder Position und/oder Ausrichtung ideal erstellt worden sind. Die Ausrichtungsgenauigkeit die erzielt werden kann ist vor allem auch abhängig von der Anzahl der für den Ausrichtungsprozess verwendeten Ausrichtungsmarken. Durch die Verwendung mehrere Ausrichtungsmarken, insbesondere jener minderer Qualität, werden Qualitätsdefizite aus dem Endergebnis herausgemittelt. Für einen Ausrichtungsprozess, der auf die Mittelung mehrere Ausrichtungsmarken angewiesen ist, ist es von besonderem Vorteil, wenn sich alle Marken einer Seite gleichzeitig im Sichtbereich einer Optik befinden.

Sollten durch den erfindungsgemäßen Prozess Fehler, die auf lokale und/oder globale Krümmungen des Substrats zurückzuführen sein, korrigiert werden, so ist eine konzentrierte Herstellung von Ausrichtungsmarken in einem Bereich, der durch den Sichtbereich der Optik abgedeckt werden kann, eher hinderlich. Die Ausrichtungsgenauigkeit würde dann durch die erfindungsgemäße Vermessung mehrere Ausrichtungsmarken, die weiter voneinander entfernt sind, steigen.

Erfindungsgemäß wird abhängig vom jeweiligen Problem eine entsprechende Lösung bevorzugt. Ist bekannt, dass die Passmarken mit minderer Qualität hergestellt werden, werden diese Vorzugsweise nahe beieinander hergestellt. Soll durch die Ausrichtungsmarken eine höhere Ausrichtungsgenauigkeit für ein stark verzerrtes und/oder gekrümmtes Substrat erzielt werden, so sind die Ausrichtungsmarken auf jeder Substratseite weiter voneinander entfernt. Die oben genannte Möglichkeit der statistischen Fehlermittelung kann also auf beide genannten Verfahren angewendet werden.

In einer besonders bevorzugten erfindungsgemäßen Ausführungsform ist es denkbar, dass es mehrere Bereiche mit jeweils mehreren Ausrichtungsmarken, gibt von denen jeder einzelne Bereich vollständig vom Sichtbereich der Optiken abgedeckt werden kann. Dadurch werden erfindungsgemäß alle Ausrichtungsmarken eines Bereichs benutzt um Qualitätsdefizite in den Ausrichtungsmarken zu kompensieren, während die Ausrichtungsmarken unterschiedlicher Bereiche verwendet werden können um die Ausrichtungsgenauigkeit bezüglich Krümmungen zu verbessern.

### Substrate und Ausrichtungsmarken

Die Substrate verfügen über eine erste Substratoberfläche und eine, der ersten Substratoberfläche gegenüberliegende, zweite Substratoberfläche. Die Substratoberfläche, die ein Teil des Bondinterfaces wird, nennt man innere Substratoberfläche, die der inneren Substratoberfläche gegenüberliegende Substratoberfläche nennt man äußere Substratoberfläche.

Im weiteren Verlauf der Druckschrift sind ausschließlich die inneren Substratoberflächen von Bedeutung. Sofern nicht anders erwähnt, sind alle in der Druckschrift genannten Substratoberflächen innere Substratoberflächen.

Eine Substratoberfläche verfügt über eine linke Substratoberflächenseite und eine rechte Substratoberflächenseite. Die linke Substratoberflächenseite umfasst dabei den gesamten Bereich der Substratoberfläche links einer Ebene, die Normal auf die Substratoberfläche steht und vorzugsweise durch die Kerbe (engl.: notch) und das Substratzentrum verläuft, bzw. vorzugsweise normal auf die Flachseite (engl.: flat) des Substrats steht und durch das Substratzentrum verläuft. Die rechte Substratoberflächenseite umfasst dabei den gesamten Bereich der Substratoberfläche rechts der Ebene, die vorzugsweise normal auf die Substratoberfläche steht und durch die Kerbe verläuft, bzw. vorzugsweise normal auf die Flachseite des Substrats steht.

Der Vollständigkeit wegen wird erwähnt, dass die Ebene nicht notwendigerweise durch die Kerbe verlaufen oder normal auf die Flachseite stehen muss. Symmetrieüberlegungen führen aber meistens dazu, dass derartige Substrate, insbesondere die funktionalen Einheiten auf den Substraten, symmetrisch bezüglich einer Ebene sind, die durch die Kerbe verläuft oder normal auf die Flachseite steht. Entsprechend der symmetrischen Verteilung der funktionalen Einheiten auf der Substratoberfläche sind dann auch die Ausrichtungsmarken symmetrisch verteilt.

Die erfindungsgemäß auszurichtenden Substrate verfügen pro Substratoberflächenseite über mindestens zwei Ausrichtungsmarken. Denkbar sind pro Substratoberflächenseite auch mehr als zwei Ausrichtungsmarken, insbesondere mehr als 3 Ausrichtungsmarken, noch bevorzugter mehr als 4 Ausrichtungsmarken, am bevorzugtesten mehr als 5 Ausrichtungsmarken, am allerbevorzugtesten mehr als 6 Ausrichtungsmarken. Die Ausrichtungsmarken einer Substratoberflächenseite befinden sich vorzugsweise innerhalb eines Kreises K mit Radius kleiner als 100 mm, vorzugsweise kleiner als 50 mm, noch bevorzugter kleiner als 25mm, am bevorzugtesten kleiner als 10 mm, am allerbevorzugtesten kleiner als 1mm.

In einer ganz besonders bevorzugten Ausführungsform befinden sich die Ausrichtungsmarken einer Substratoberflächenseite auf demselben Radius des Substrats. In einer ganz besonders bevorzugten erfindungsgemäßen Ausführungsform befinden sich alle Ausrichtungsmarken beider Substratoberflächenseiten auf demselben Durchmesser des Substrats.

Eine weitere Einteilung der Ausrichtungsmarken erfolgt über deren Position in Bezug zum Zentrum des Substrats. Die Ausrichtungsmarken, die dem Zentrum des Substrats am nächsten liegen, werden als innere Ausrichtungsmarken bezeichnet. Die Ausrichtungsmarken, die am weitesten vom Zentrum entfernt liegen, werden als äußere Ausrichtungsmarken bezeichnet. Um den erfindungsgemäßen Prozess in der Beschreibung möglichst einfach zu halten, wird im weiteren Verlauf nur mehr von zwei Ausrichtungsmarken pro Substratoberflächenseite gesprochen werden. Eine Erweiterung der erfindungsgemäßen Ausführungsform auf mehr als zwei (n) Ausrichtungsmarken bzw. eine Erweiterung der erfindungsgemäßen Ausführungsform auf eine wiederholte Vermessung derselben Ausrichtungsmarken pro Substratoberflächenseite erfolgt dann durch Analogieüberlegung. Eine Erweiterung der erfindungsgemäßen Ausführungsform auf mehr als zwei Ausrichtungsmarken bzw. eine Erweiterung der erfindungsgemäßen Ausführungsform auf eine wiederholte Vermessung derselben Ausrichtungsmarken pro Substratoberflächenseite wird auch durch die Schleife in dem angegebenen Flussdiagramm graphisch offenbart.

### Kalibrierprozess

Vor dem eigentlichen erfindungsgemäßen Prozess erfolgt eine Kalibrierung der Optiken der Ausrichtungseinrichtung. Entsprechende Anlagen zur Ausrichtung von Substraten sind in den Druckschriften US6214692B1, PCT/EP2013/075831, WO2011042093A1 und WO2014202106A1 offenbart und werden daher hier nicht mehr ausführlich beschrieben.

Das erfindungsgemäße Verfahren arbeitet mit mindestens vier Optiken, die vorzugsweise zu jeweils zwei Optikgruppen gruppiert werden. Jede Optik einer Optikgruppe kann zwar einzeln bewegt, insbesondere translatorisch bewegt und/oder rotiert, werden, ist nach der Kalibrierung zur jeweils gegenüberliegenden Optik aber fixiert. Durch eine translatorische und/oder rotatorische Bewegung der Optikgruppe bewegen sich nach der Fixierung daher beide Optiken gleichzeitig. Diese starre Fixierung der Optiken zueinander wird vorzugsweise nach dem jeweiligen, im folgenden Abschnitt näher erläuterten, Kalibrierprozess nicht mehr aufgehoben.

Die Kalibrierung der Optiken einer Optikgruppe zielt darauf ab, den Schnittpunkt der optischen Achsen festzulegen. Der Tiefenschärfebereich beinhaltet gleichzeitig den Bereich der späteren Fokusebenen.

Die Optiken werden auf Ausrichtungsmarken kalibriert. Die Ausrichtungsmarke befindet sich vorzugsweise in einem, insbesondere transparenten, Kalibriersubstrat. Allerdings können auch Ausrichtungsmarken verwendet werden, die sich auf der Oberfläche eines Kalibriersubstrats befinden.

In einem ersten Kalibrierschritt wird die erste Optik der ersten Optikgruppe einer ersten Seite auf eine erste Ausrichtungsmarke fokussiert. Die Optik wird vorzugsweise so kalibriert, dass sich die erste Ausrichtungsmarke im Zentrum des Tiefenschärfebereichs befindet.

In einem zweiten Kalibrierschritt wird die zweite Optik der ersten Optikgruppe der ersten Seite auf dieselbe, erste Ausrichtungsmarke fokussiert. Die Optik wird vorzugsweise so kalibriert, dass sich die erste Ausrichtungsmarke im Zentrum des Tiefenschärfebereichs befindet. Insbesondere verfährt die Optik in x- und/oder y- und/oder z-Richtung bzw. führt Rotation um die x- und/oder y- und/oder z-Achse durch. Die Ausrichtungsmarke befindet sich nach dem Kalibrierprozess vorzugsweise genau im Zentrum des Sichtbereichs.

Im Allgemeinen stehen die optischen Achsen der beiden ersten Optiken nicht normal auf die Fokussierebene. Vorzugsweise schneiden sich die optischen Achsen daher in der ersten Ausrichtungsmarke. Nach diesem Kalibrierschritt werden die beiden Optiken der ersten Optikgruppe nicht mehr zueinander bewegt.

In einem dritten Kalibrierschritt wird die erste Optik der zweiten Optikgruppe der zweiten Seite auf eine zweite Ausrichtungsmarke fokussiert. Die Optik wird vorzugsweise so kalibriert, dass sich die Ausrichtungsmarke im Zentrum des Tiefenschärfebereichs befindet.

In einem vierten Kalibrierschritt wird die zweite Optik der zweiten Optikgruppe der zweiten Seite auf dieselbe, zweite Ausrichtungsmarke fokussiert. Die Optik wird vorzugsweise so kalibriert, dass sich die Ausrichtungsmarke im Zentrum des Tiefenschärfebereichs befindet.

Im Allgemeinen stehen die optischen Achsen der beiden zweiten Optiken nicht normal auf die Fokussierebene. Vorzugsweise schneiden sich die optischen Achsen daher in der zweiten Ausrichtungsmarke. Nach diesem Kalibrierschritt werden die beiden Optiken der zweiten Optikgruppe nicht mehr zueinander bewegt.

Denkbar ist auch die Verwendung eines Kalibriersubstrats, das nur über eine Ausrichtungsmarke verfügt, die dann zwischen den Kalibrierschritten der ersten Seite und den Kalibrierschritten der zweiten Seite verschoben werden muss. Dabei muss die Ausrichtungsmarke bei der translatorischen Verschiebung des Kalibriersubstrats eine möglichst konstante z-Position, insbesondere unter der Annahme eines ebenen Substrats, beibehalten. Im Allgemeinen müssen die z-Abstände zur Substratoberfläche bei allen Positionen des Substrats konstant sein. Ist das Substrat beispielsweise gekrümmt, so muss bei einer translatorischen Verschiebung des Substrats relativ zu den Optiken, vorzugsweise eine Nachkorrektur der Optiken und/oder des Substrats in z-Richtung erfolgen. Bei vernachlässigbaren Krümmungen kann auf derartige Korrekturen verzichtet werden. Nach der Kalibrierung befindet sich die Fokussierebene innerhalb der Tiefenschärfebereiche aller vier Optiken. Die Fokussierebene und die spätere Bondebene fallen vorzugsweise zusammen. Nachdem eine Kalibrierung der Optiken vorgenommen wurde, kann der eigentliche erfindungsgemäße Prozess beginnen. Der Kalibrierprozess kann in der WO2014202106A1 nachgelesen werden.

Die Auflösung der Optiken liegt zwischen 10000 nm und 10 nm, vorzugsweise zwischen 5000 nm und 50 nm, noch bevorzugter zwischen 1000 nm und 100 nm, am bevorzugtesten zwischen 750 nm und 380 nm.

Die Auflösung wird dabei vorzugsweise nach dem Rayleigh-Kriterium definiert.

Der Vollständigkeit halber wird offenbart, dass das erfindungsgemäße Verfahren auch mit Ausrichtungsanlagen funktioniert, bei denen die Optiken einer Seite nicht in einer Optikgruppe miteinander mechanisch gekoppelt sind. Eine derartige Ausrichtungsanlage wird beispielsweise in der Druckschrift WO2011042093A1 erwähnt. Bei einer solchen Ausrichtungsanlage müssen eine obere und eine untere Optik nicht notwendigerweise gegenüberliegend positioniert sein, sondern können in der x-y Ebene auch voneinander beabstandet sein. Eine derartige Ausrichtungsanlage kann allerdings auch verwendet werden, um den erfindungsgemäßen Prozess durchzuführen.

### Vermessungsprozess

Im Stand der Technik existieren mehrere Anlagen mit unterschiedlichen Ausrichtungskonzepten. Die für diese Erfindung relevantesten Anlagen werden in den Druckschriften US6214692B1 und WO2014202106A1 offenbart.

Die Druckschrift US6214692B1 beschreibt eine Anlage, bei der die Substrate wechselseitig zwischen die Optiken geschoben werden, die sich vor oder hinter dem Substratstapel befinden.

Die Druckschrift WO2014202106A1 hingegen beschreibt eine Anlage, bei der die Substrate wechselseitig zwischen Optiken geschoben werden, die sich seitlich des Substratstapels befinden. Der erfindungsgemäß offenbarte, verbesserte Ausrichtungsprozess lässt sich auf alle genannten Ausrichtungsanlagen anwenden, insbesondere aber auch auf die WO2014202106A1. Der erfindungsgemäß offenbarte, verbesserte Ausrichtungsprozess wird aber anhand der offenbarten Ausrichtungsanlage in der Patentschrift US6214692B1 exemplarisch dargestellt.

Die erfindungsgemäße Methode kann grundsätzlich auf alle bekannten Ausrichtungsverfahren angewandt und von fast allen Ausrichtungsanlagen durchgeführt werden.

Die zueinander auszurichtenden Substrate sind auf Probenhaltern fixiert. Die Probenhalter verfügen über Fixierungen. Die Fixierungen dienen dem Festhalten der Substrate. Bei den Fixierungen kann es sich um
- Mechanische Fixierungen, insbesondere
   o Klemmen
- Vakuumfixierungen, insbesondere mit
   o einzeln ansteuerbare Vakuumbahnen
   o miteinander verbundenen Vakuumbahnen
   o als Teil eines Noppenprobenhalters (engl.: pin chuck, siehe beispielsweise WO2015113641A1)
- Elektrische Fixierungen, insbesondere
   o Elektrostatische Fixierungen
- Magnetische Fixierungen
- Adhäsive Fixierungen, insbesondere
   o Gel-Pak Fixierungen
   o Fixierungen mit adhäsiven, insbesondere ansteuerbaren, Oberflächen
handeln. Die Fixierungen sind insbesondere elektronisch ansteuerbar. Die Vakuumfixierung ist die bevorzugte Fixierungsart. Die Vakuumfixierung besteht vorzugsweise aus mehreren Vakuumbahnen, die an der Oberfläche des Probenhalters austreten. Die Vakuumbahnen sind vorzugsweise einzeln ansteuerbar. In einer technisch eher realisierbaren Anwendung sind einige Vakuumbahnen zu Vakuumbahnsegmenten vereint, die einzeln ansteuerbar, daher evakuiert oder geflutet werden können. Jedes Vakuumsegment ist allerdings unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig konstruiert. Dadurch wird eine gezielte, radialsymmetrische, insbesondere von Innen nach Außen durchgeführte Fixierung und/oder Loslösung eines Substrats vom Probenhalter ermöglicht. In einer ganz bevorzugten Ausführungsform ist der Probenhalter als Noppenprobenhalter (engl.: pin chuck) ausgeführt. Dabei handelt es sich um einen Probenhalter, bei dem viele, insbesondere symmetrisch angeordnete Erhebungen, insbesondere Nadeln, aus der Oberfläche erzeugt wurden, deren Umgebung evakuiert werden kann. Das Substrat liegt nur auf den Köpfen der Erhebungen auf. Die Kontaktfläche ist dementsprechend gering. Eine Ausführungsform eines Nadel-Probenhalters wird in der Druckschrift WO2015113641A1 offenbart.

Im weiteren Verlauf der erfindungsgemäßen Ausführungsform wird eine Verschiebung der Optiken von den inneren zu den äußeren Ausrichtungsmarken beschrieben. Der erfindungsgemäße Prozess funktioniert allerdings auch dann, wenn die Ausrichtungsmarken von außen nach innen, oder sogar in beliebiger Reihenfolge, vermessen werden. Denkbar, wenn auch nicht bevorzugt, ist die Vermessung der Ausrichtungsmarken von innen nach außen auf der ersten Substratoberflächenseite und eine Vermessung der Ausrichtungsmarken von außen nach innen auf der zweiten Substratoberflächenseite.

Der Verlauf der erfindungsgemäßen Ausführungsform besteht darin, dass sich pro Substratoberflächenseite mehrere Ausrichtungsmarken im Sichtbereich (engl.: field of view) einer Optik befinden, sodass eine Verschiebung der Optiken nach außen oder nach innen gar nicht notwendig ist. Dadurch wird es erfindungsgemäß sogar möglich, mehrere Ausrichtungsmarken zu vermessen, ohne die Optikgruppen verschieben zu müssen.

In einer noch viel bevorzugteren erfindungsgemäßen Ausführungsform befinden sich nicht nur mehrere Ausrichtungsmarken pro Substratoberflächenseite im Sichtbereich der Optik, sondern sind sogar ineinander verschachtelt, ohne sich zu berühren. Dadurch ist eine besonders effiziente Unterbringung mehrerer Ausrichtungsmarken pro Einheitsfläche machbar. Dadurch wird es erfindungsgemäß besonders effizient möglich, mehrere Ausrichtungsmarken zu vermessen, ohne die Optikgruppen verschieben zu müssen.

In einem ersten erfindungsgemäßen Prozessschritt erfolgt die Vermessung der unteren, inneren Ausrichtungsmarken des unteren Substrats. Dazu wird das obere Substrat, falls notwendig, aus dem Sichtbereich der oberen Optiken gefahren, sodass die oberen Optiken freie Sicht auf die unteren, inneren Ausrichtungsmarken des unteren Substrats haben. Vorzugsweise befinden sich die unteren, inneren Ausrichtungsmarken bereits im Sichtbereich (engl.: field of view) der oberen Optiken, sodass die Optikgruppen nicht verfahren werden müssen. Das Verfahren der Einzeloptiken ist zu diesem Zeitpunkt nicht mehr erwünscht. Von nun an werden nur noch die Optikgruppen verfahren. Nachdem die unteren, inneren Ausrichtungsmarken vermessen worden sind, existiert eine eindeutige Zuordnung zwischen der unteren Probenhalterposition und den unteren, inneren Ausrichtungsmarken.

In einem zweiten erfindungsgemäßen Prozessschritt verfährt der obere Probenhalter mit dem oberen Substrat über das untere Substrat. Insbesondere gleichzeitig wird der untere Probenhalter mit dem unteren Substrat zurückgefahren. Dabei erfolgt vorzugsweise eine sogenannte Positionsfehlerkorrektur (engl.: position error correction, PEC). Darunter versteht man die Vermessung der Position des unteren Probenhalters durch Messgeräte, insbesondere durch Interferometer und/oder weitere, spezielle Optiken, die im Weiteren als PEC Optiken bezeichnet werden. Die Positionsfehlerkorrektur ist notwendig, da das untere Substrat während seiner Bewegung aus dem Sichtbereich der oberen Optiken von diesen nicht beobachtet werden kann, da sich im allgemeinen bereits das obere Substrat in deren Sichtbereich geschoben hat. Um das untere Substrat in späteren Prozessschritten mit hoher Präzession wieder in seine angestammte Position fahren zu können, muss die Position während der Bewegung aus dem Sichtbereich der Optiken exakt vermessen werden. Vorzugsweise verwendet man zur kontinuierlichen Vermessung der Position des unteren Probenhalters Interferometer. Noch bevorzugter werden zusätzliche Optiken, PEC Optiken, verwendet, die von den genannten Optiken zur Erfassung der Ausrichtungsmarken gänzlich unabhängig sind. Diese PEC Optiken vermessen Markierungen auf dem unteren Probenhalter und können damit, insbesondere zu jedem Zeitpunkt, die Position des Probenhalters angeben. Mit Vorzug wird die Position des unteren Substrathalters zumindest vor der translatorischen Verschiebung gemessen. Damit kann gewährleistet werden, dass die Position jederzeit wiederhergestellt werden kann. Durch die so vermessenen Probenhalterpositionen kann der untere Probenhalter, und damit das untere Substrat, zu jedem Zeitpunkt wieder in seine angestammte Position gebracht werden.

Die Genauigkeit, mit der die Positionserfassung der Probenhalter für die Positionsfehlerkorrektur durchgeführt wird ist besser als 1 µm, vorzugsweise besser als 500 nm, noch bevorzugter besser als 100 nm, am bevorzugtesten besser als 50 nm, am allerbevorzugtesten besser als 10 nm.

In einem dritten erfindungsgemäßen Prozessschritt erfolgt die Vermessung der oberen, inneren Ausrichtungsmarken des oberen Substrats. Vorzugsweise befinden sich die oberen, inneren Ausrichtungsmarken bereits im Sichtbereich (engl.: field of view) der unteren Optiken, sodass die Optikgruppen nicht verfahren werden müssen. Das Verfahren der einzelnen Optiken ist zu diesem Zeitpunkt nicht mehr erlaubt. Nachdem die oberen, inneren Ausrichtungsmarken vermessen worden sind, existiert eine eindeutige Zuordnung zwischen der oberen Probenhalterposition und den oberen, inneren Ausrichtungsmarken. Insbesondere wird in einem weiteren Vorgang der obere Probenhalter fixiert.

In einem vierten Prozessschritt erfolgt eine Bewegung der Optikgruppen so, dass die oberen, äußeren Ausrichtungsmarken sich im Sichtbereich der unteren Optiken befinden. Nachdem die oberen, äußeren Ausrichtungsmarken vermessen worden sind, existiert eine eindeutige Zuordnung zwischen der oberen Probenhalterposition und den oberen, äußeren Ausrichtungsmarken. Um den Bezug zu den zuvor erfassten oberen, äußeren Ausrichtungsmarken nicht zu verlieren wird hier mit Vorzug die Position der unteren Optiken präzise, vorzugsweise mit optischen Messmitteln, noch bevorzugter mittels Interferometrie überwacht. So kann der zurückgelegte Weg der Optiken erfasst werden. In einem fünften Prozessschritt erfolgt die Positionierung des unteren Substrats. Dabei werden die im Prozessschritt zwei vermessenen Positionen aus der Positionstehlerkorrektur verwendet, um das untere Substrat wieder korrekt in seiner ursprünglichen Position zu positionieren.

Insbesondere gleichzeitig verfährt das obere Substrat aus dem Sichtbereich der oberen Optiken.

In einem sechsten Prozessschritt erfolgt eine Bewegung der Optikgruppen, so dass die unteren, äußeren Ausrichtungsmarken sich im Sichtbereich der oberen Optiken befinden. Nachdem die unteren, äußeren Ausrichtungsmarken vermessen worden sind, existiert eine eindeutige Zuordnung zwischen der unteren Probenhalterposition und den unteren, äußeren Ausrichtungsmarken. Um den Bezug zu den zuvor erfassten unteren, äußeren Ausrichtungsmarken nicht zu verlieren wird hier mit Vorzug die Position der oberen Optiken präzises, vorzugsweise mit optischen Messmitteln, noch bevorzugter mittels Interferometrie überwacht. So kann der zurückgelegte Weg der Optiken erfasst werden.

Erfindungsgemäß existieren zu diesem Zeitpunkt die Positionen der oberen und unteren, äußeren und inneren Ausrichtungsmarken. Der erfindungsgemäße Prozess kann nun an weiteren Ausrichtungsmarken durchgeführt werden. In diesem Fall erhöht sich die Anzahl der, für die Statistik und Fehlerkorrektur zur Verfügung stehenden Daten. Die Anzahl der Ausrichtungsmarken pro Substratoberflächenseite kann im Allgemeinen beliebig groß sein. Die Anzahl der Ausrichtungsmarke pro Substratoberflächenseite ist größer als 1, vorzugsweise größer als 2, noch bevorzugter größer als 5, am bevorzugtesten größer als 10, am allerbevorzugtesten größer als 20.

Denkbar ist auch, die Vermessung an den Ausrichtungsmarken zu wiederholen. Durch einen kontinuierlichen Wechsel zwischen inneren und äußeren Ausrichtungsmarken sind eine statistische Auswertung der Ausrichtungspositionen und damit eine Ermittlung einer noch optimaleren, insbesondere imaginären Ausrichtungsmarke, möglich.

Erfindungsgemäß müssen die Optikgruppen nach der Kalibrierung gar nicht mehr bewegt werden, da sich mindestens zwei Ausrichtungsmarken pro Substratoberflächenseite im Sichtbereich einer jeden Optik befinden. Es müssen demnach nur die Schritte eins bis drei des vorherigen Prozesses durchgeführt werden, um pro Substratoberflächenseite mindestens zwei Ausrichtungsmarken zu vermessen.

### Berechnungsprozess

Der Berechnungsprozess beruht kurz gesagt darauf, dass zwischen den korrespondierenden Ausrichtungsmarken der Ober- und Unterseite eine Fehlerminimierung durchgeführt wird. Vorzugsweise wird die Methode der kleinsten Quadrate verwendet. Die Fehlerminimierung führt zu einer idealen X-Y Position und/oder Rotationsstellung des unteren Probenhalters, sowie zu einer idealen X-Y Position und/oder Rotationsstellung des oberen Probenhalters, an denen die Substrate optimal zueinander ausgerichtet sind und in einem weiteren Prozessschritt miteinander kontaktiert, insbesondere gebondet werden können.

### Kontaktierungsprozess / Bondprozess

Nach der Berechnung der statistisch gemittelten Positionen erfolgt das Bonden beider Substrate miteinander. Die Ausrichtung der Substrate erfolgt in Bezug auf die statistisch gemittelten Positionen. Die Substrate werden in die vorgesehenen Positionen verfahren. Danach erfolgt eine Annäherung der beiden Substrate in z-Richtung. Insbesondere wird ein Fusionsbond, noch bevorzugter ein Hybridbond, durchgeführt. Bei einem Fusionsbond wird, insbesondere das obere, Substrat durch einen Pin in eine, vom Bondinterface aus betrachtet, konvexe Form gekrümmt. Das gekrümmte Substrat kontaktiert das zweite, insbesondere flache, Substrat vorzugsweise zentrisch.

Der Ausrichtungs- und Bondprozess kann mit einer Reproduzierbarkeit zwischen 150-250 nm, vorzugsweise zwischen 125-225 nm, noch bevorzugter zwischen 100-200 nm, am bevorzugtesten zwischen 75-150 nm, am allerbevorzugtesten zwischen 50-100 nm durchgeführt werden.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1a: eine schematische, nicht maßstabsgetreue Oberansicht einer idealen Ausrichtungsmarke im Sichtbereich,
- Figur 1b: eine schematische, nicht maßstabsgetreue Oberansicht mehrerer idealer Ausrichtungsmarken im Sichtbereich,
- Figur 1c: eine schematische, nicht maßstabsgetreue Oberansicht mehrerer idealer zentriert ausgerichteter Ausrichtungsmarken im Sichtbereich,
- Figur 2: eine schematische, nicht maßstabsgetreue Oberansicht einer nicht idealen Ausrichtungsmarke,
- Figur 3: eine schematische, nicht maßstabsgetreue Oberansicht einer Überlagerung einer idealen Ausrichtungsmarke mit einer nicht idealen Ausrichtungsmarke,
- Figur 4: eine schematische, nicht maßstabsgetreue Oberansicht eines ersten Substrattyps mit Kerbe,
- Figur 5: eine schematische, nicht maßstabsgetreue Oberansicht eines zweiten Substrattyps mit Flachseite, Prozessflusses,
- Figur 6: eine Darstellung eines
- Figur 7a: eine schematische, nicht maßstabsgetreue Oberansicht eines erfindungsgemäßen ersten Prozessschrittes,
- Figur 7b: eine schematische, nicht maßstabsgetreue Seitenansicht eines erfindungsgemäßen ersten Prozessschrittes,
- Figur 8a: eine schematische, nicht maßstabsgetreue Unteransicht eines erfindungsgemäßen zweiten Prozessschrittes,
- Figur 8b: eine schematische, nicht maßstabsgetreue Seitenansicht eines erfindungsgemäßen zweiten Prozessschrittes,
- Figur 9a: eine schematische, nicht maßstabsgetreue Unteransicht eines erfindungsgemäßen dritten Prozessschrittes,
- Figur 9b: eine schematische, nicht maßstabsgetreue Seitenansicht eines erfindungsgemäßen dritten Prozessschrittes,
- Figur 10a: eine schematische, nicht maßstabsgetreue Unteransicht eines vierten Prozessschrittes,
- Figur 10b: eine schematische, nicht maßstabsgetreue Seitenansicht eines vierten Prozessschrittes,
- Figur 11a: eine schematische, nicht maßstabsgetreue Oberansicht eines fünften Prozessschrittes,
- Figur 11b: eine schematische, nicht maßstabsgetreue Seitenansicht eines fünften Prozessschrittes,
- Figur 12a: eine schematische, nicht maßstabsgetreue Oberansicht eines sechsten Prozessschrittes,
- Figur 12b: eine schematische, nicht maßstabsgetreue Seitenansicht eines sechsten Prozessschrittes und
- Figur 13: eine graphische Darstellung der Reduktion des Ausrichtungsfehlers als Funktion der Anzahl der vermessenen Ausrichtungsmarken.

In den Figuren sind gleiche Bauteile oder Bauteile mit der gleichen Funktion mit den gleichen Bezugszeichen gekennzeichnet.

In den folgenden Figurenbeschreibungen gilt folgende Nomenklatur. Elemente der linken Substratseite werden mit einem kleinen 1 (germ: links) indiziert. Elemente der rechten Substratseite werden mit einem kleinen r (germ: rechts) indiziert. Elemente der Oberseite werden mit einem kleinen o (germ: oben) indiziert. Elemente der Unterseite werden mit einem kleinen u (germ: unten) indiziert.

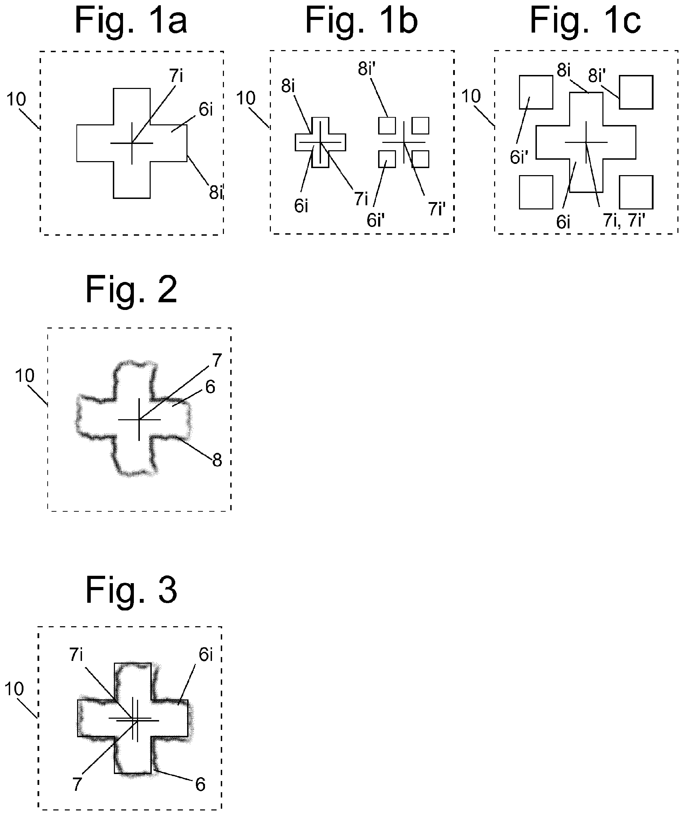

Die Figur 1a zeigt eine schematische, nicht maßstabsgetreue Darstellung einer einzelnen, idealen Ausrichtungsmarke 6i in einem Sichtbereich 10 einer Optik. Die Ausrichtungsmarke 6i besitzt gerade Kanten 8i, wird insbesondere telezentrisch aufgenommen, besitzt einen möglichst guten Kontrast zur Umgebung, ist symmetrisch und insbesondere nicht verzerrt. Eine Ausrichtungsmarke 6i mit einer dermaßen hohen Qualität ist nur schwer herzustellen. Eine Software würde aus der idealen Ausrichtungsmarke 6i eine ideale, zentrische Position 7i, berechnen.

Die Figur 1b zeigt eine schematische, nicht maßstabsgetreue Darstellung zweier, idealer Ausrichtungsmarken 6i, 6i' in einem Sichtbereich 10. Die Ausrichtungsmarken 6i und 6i' sind klein genug und nahe genug beieinander, dass sie sich gleichzeitig im Sichtbereich 10 einer betrachtenden Optik 11ol, 11or, 11ul, 11ur befinden. Dadurch wird es erfindungsgemäß möglich, ein Verfahren der Optikgruppe zwischen den beiden Ausrichtungsmarken 6i und 6i' zu vermeiden. Gleichzeitig können aber beide Ausrichtungsmarken 6i und 6i' vermessen werden. Die Ausrichtungsmarken 6i und 6i'besitzen gerade Kanten 8i und 8i', werden insbesondere telezentrisch aufgenommen, besitzen möglichst guten Kontrast zur Umgebung, sind symmetrisch und insbesondere nicht verzerrt. Ausrichtungsmarken 6i und 6i' mit einer dermaßen hohen Qualität sind nur schwer herzustellen. Eine Software würde aus den idealen Ausrichtungsmarken 6i und 6i' zwei ideale, zentrische Position 7i und 7i', berechnen.

Die Figur 1c zeigt eine schematische, nicht maßstabsgetreue Darstellung zweier, idealer Ausrichtungsmarken 6i, 6i' in einem Sichtbereich 10. Die Ausrichtungsmarken 6i und 6i' sind insbesondere so konstruiert, dass sie ineinander verschachtelt sind, sich aber nicht berühren. Beide Ausrichtungsmarken 6i und 6i' befinden sich gleichzeitig im Sichtbereich 10 einer betrachtenden Optik 11ol, 11or, 11ul, 11ur. Dadurch wird es erfindungsgemäß möglich, ein Verfahren der Optikgruppe zwischen den beiden Ausrichtungsmarken 6i und 6i' zu vermeiden. Gleichzeitig können aber beide Ausrichtungsmarken 6i und 6i' vermessen werden. Die Ausrichtungsmarken 6i und 6i'besitzen gerade Kanten 8i und 8i', werden insbesondere telezentrisch aufgenommen, besitzen möglichst guten Kontrast zur Umgebung, sind symmetrisch und insbesondere nicht verzerrt. Ausrichtungsmarken 6i und 6i' mit einer dermaßen hohen Qualität sind nur schwer herzustellen. Eine Software würde aus den idealen Ausrichtungsmarken 6i und 6i' zwei ideale, zentrische Position 7i und 7i', berechnen.

Auf die Darstellung analoger Figuren 2b, 2c, 3b und 3c für die nicht ideale Ausrichtungsmarken 6 wird im Weiteren verzichtet. Der Fachmann versteht, dass die Betrachtungen der idealen Ausrichtungsmarken 6i, 6i' auf die nicht idealen Ausrichtungsmarken 6 übertragen werden kann.

Die Figur 2 zeigt eine schematische, nicht maßstabsgetreue Darstellung einer nicht idealen Ausrichtungsmarke 6. Die Abweichungen von der gewünschten, idealen Form sind übertrieben dargestellt um die Darstellung zu erleichtern. Im Allgemeinen besitzt eine nicht ideale Ausrichtungsmarke 6 nicht ideale, ungerade Kanten 8. Des Weiteren kann die nicht ideale Ausrichtungsmarke 6 verzerrt sein oder nicht telezentrisch aufgenommen werden, was zu einem unscharfen Kontrast der nicht idealen, ungeraden Kanten 8 führen kann. Eine Software würde aus der nicht idealen Ausrichtungsmarke 6 eine nicht ideale, zentrische Position 7, berechnen. Analog zu Figur 1b sind auch zwei kleine und nahe beieinander liegende Ausrichtungsmarken 6, 6' in einem Sichtbereich 10 denkbar. Analog zu Figur 1c sind auch zwei zueinander komplementäre Ausrichtungsmarken 6, 6' in einem Sichtbereich 10 denkbar.

Die Figur 3 zeigt eine schematische, nicht maßstabsgetreue Darstellung einer Überlagerung einer idealen Ausrichtungsmarke 6i und einer nicht idealen Ausrichtungsmarke 6. Im Zentrum der jeweiligen Ausrichtungsmarken 6, 6i sind die mittels einer Software berechneten zentrischen Positionen 7, 7i der Ausrichtungsmarken 6, 6i dargestellt. Die nicht ideale zentrische Positionen 7 weicht dabei von der gewünschten, idealen zentrischen Position 7i ab. Dieser Fehler ist auf die nicht idealen Merkmale der nicht idealen Ausrichtungsmarke 6, insbesondere die nicht idealen, ungeraden Kanten 8, zurückzuführen und erzeugt einen Fehler, der durch den erfindungsgemäßen Prozess weitestgehend kompensiert werden soll. Auch hier gelten die Analogieüberlegungen zu den Figuren 1b und 1c.

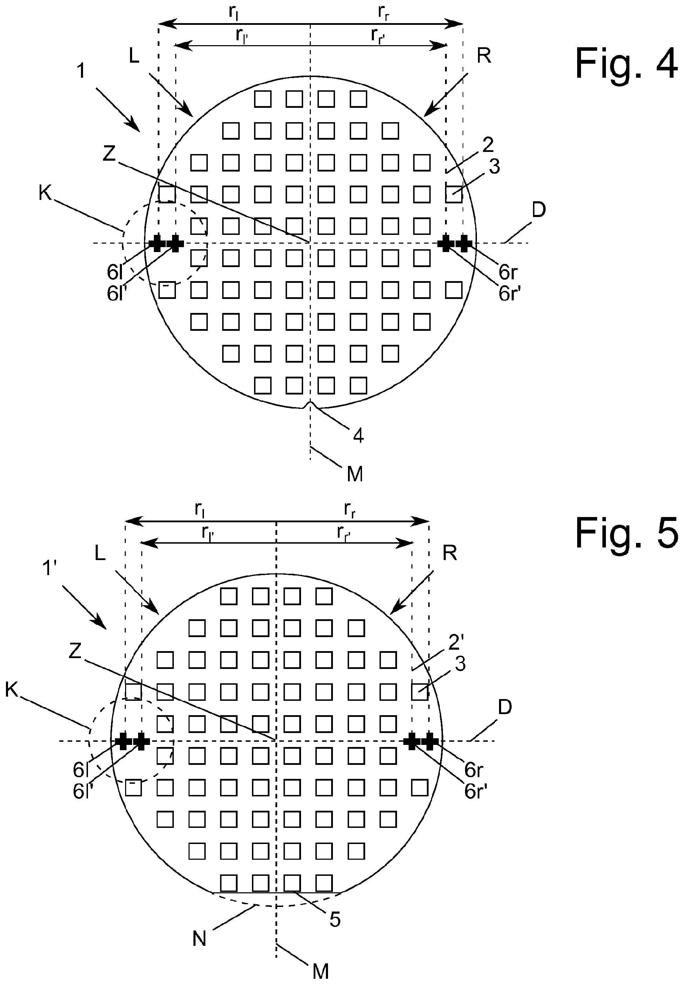

Die Figur 4 zeigt einen ersten Substrattyp 1, bestehend aus einem Substrat 2 mit mehreren, insbesondere symmetrisch gefertigten, funktionalen Einheiten 3. Der erste Substrattyp 1 verfügt über eine Kerbe 4. Durch die symmetrische Anordnung der funktionalen Einheiten 3 ist eine symmetrische Anordnung der Ausrichtungsmarken 6l, 6l', 6r und 6r' naheliegend, aber nicht zwingend erforderlich. Vorzugsweise wird der Substrattyp 1 daher durch eine Ebene, insbesondere Symmetrieebene, M in einen linken Bereich L und einen rechten Bereich R getrennt. Erfindungsgemäß befinden sich im linken Bereich L mindestens zwei Ausrichtungsmarken 6l und 6l' und im rechten Bereich mindestens zwei Ausrichtungsmarken 6r und 6r`. Die Ausrichtungsmarken 61, 6l', 6r und 6r' befinden sich in den Abständen rl, rl', rr und rr' vom Zentrum Z des Substrats 2. Vorzugsweise befinden sich die Ausrichtungsmarken 61, 6l', 6r und 6r' auf einer Durchmesserlinie D.

Die Figur 5 zeigt einen zweiten Substrattyp 1', bestehend aus einem Substrat 2' mit mehreren, insbesondere symmetrisch gefertigten, funktionalen Einheiten 3. Der zweite Substrattyp 1' verfügt über eine Flachseite 5. Durch die symmetrische Anordnung der funktionalen Einheiten 3 ist eine symmetrische Anordnung der Ausrichtungsmarken 6l, 6l', 6r und 6r' naheliegend, aber nicht zwingend erforderlich. Vorzugsweise wird der Substrattyp 1 daher durch eine Ebene, insbesondere Symmetrieebene, M in einen linken Bereich L und einen rechten Bereich R getrennt. Erfindungsgemäß befinden sich im linken Bereich L mindestens zwei Ausrichtungsmarken 61 und 61' und im rechten Bereich mindestens zwei Ausrichtungsmarken 6r und 6r'. Die Ausrichtungsmarken 6l, 6l', 6r und 6r' befinden sich in den Abständen rl, rl', rr und rr' vom Zentrum Z des Substrats 2'. Vorzugsweise befinden sich die Ausrichtungsmarken 6l, 6l', 6r und 6r' auf einer Durchmesserlinie D.

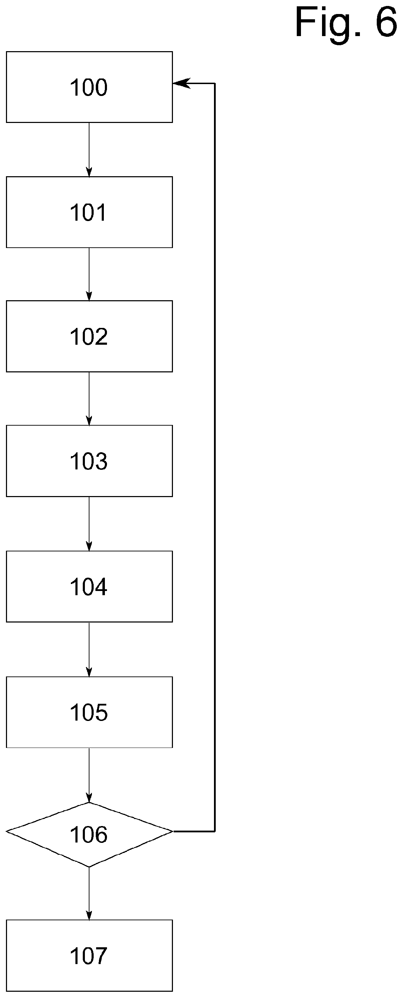

Die Figur 6 zeigt einen schematischen Prozessfluss des Prozessschritt 100 erfolgt die Vermessung der unteren, inneren Ausrichtungsmarken 6ul, 6ur des unteren Substrats 2u. In einem weiteren erfindungsgemäßen zweiten Prozessschritt 101 erfolgt die Positionsfehlerkorrektur des unteren Probenhalters 12u. In einem weiteren erfindungsgemäßen dritten Prozessschritt 102 erfolgt die Vermessung der oberen, inneren Ausrichtungsmarken 6ol, 6or des oberen Substrats 2o. In einem weiteren vierten Prozessschritt 103 erfolgt die Vermessung der oberen, äußeren Ausrichtungsmarken 6ol', 6or' des oberen Substrats 2o. In einem weiteren fünften Prozessschritt 104 erfolgt ein Wechsel der Probenhalter 12u, 12o. In einem weiteren sechsten Prozessschritt 105 erfolgt die Vermessung der unteren, äußeren Ausrichtungsmarken 6ul', 6ur'. In einem siebten Prozessschritt 106 wird entschieden, ob weitere Ausrichtungsmarken gemäß demselben Prozessablauf vermessen werden, oder ob die vermessenen Ausrichtungsmarken erneut vermessen werden. In einem erfindungsgemäß letzten, achten Prozessschritt 107 erfolgt dann die Ausrichtung und das Bonden der beiden Substrate 2u, 2o.

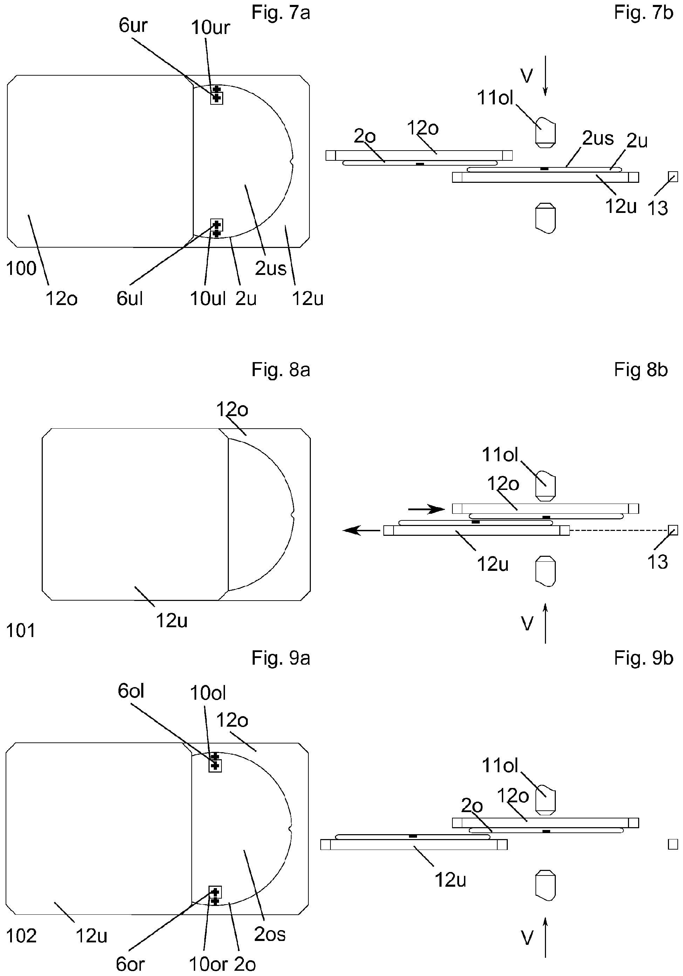

Die Figur 7a bzw. die Figur 7b zeigen eine schematische Oberansicht bzw. Seitenansicht eines ersten erfindungsgemäßen Prozessschritts 100, bei dem ein erstes, unteres Substrat 2u mit einer Substratoberfläche 2us (s=surface) auf einem ersten, unteren Probenhalter 12u fixiert wird. Der zweite, obere Probenhalter 12o, auf dem das zweite, obere Substrat 2o fixiert wird befindet sich im ersten erfindungsgemäßen Prozessschritt 100 soweit von den unteren, inneren Ausrichtungsmarken 6ul und 6ur entfernt in einer Warteposition, dass die obere linke Optik 10ol und die obere rechte Optik 10or (verdeckt in der Seitenansicht) freie Sichtfelder (engl.: field of view) 10ul und 10ur auf die beiden unteren, inneren Ausrichtungsmarken 6ul und 6ur haben. In diesem erfindungsgemäßen Ausrichtungsschritt erfolgt eine erste Speicherung der Positionen der unteren, inneren Ausrichtungsmarken 6ul und 6ur, sowie der Position des Probenhalters 12u in der Vermessungsposition für das untere Substrat 2u.

Die Figur 8a bzw. die Figur 8b zeigen eine schematische Unteransicht bzw. Seitenansicht eines zweiten erfindungsgemäßen Prozessschritts 101, bei dem der zweite, obere Probenhalter 12o in die Vermessungsposition für die oberen Ausrichtungsmarken 6ol, 6or gefahren wird. Insbesondere gleichzeitig verfährt der unteren Probenhalter 12u in seine Warteposition. Während des Verfahrens kann eine kontinuierliche Überwachung und/oder Speicherung und/oder Vermessung und/oder Korrektur des unteren Probenhalters 12u durchgeführt werden, um die zuvor hochgenau vermessene Position der Ausrichtungsmarken 6ul und 6ur später wieder exakt auffinden zu können. Diese Positionsfehlerkorrektur erfolgt durch ein PEC Messsystem 13, insbesondere ein Interferometer. In noch bevorzugteren Ausführungsformen erfolgt die Positionsfehlerkorrektur durch zusätzliche PEC Optiken, die sich allerdings unterhalb des Probenhalters 12u befinden. Derartige PEC Optiken wurden der Übersichtlichkeit halber nicht eingezeichnet.

Die Figur 9a bzw. die Figur 9b zeigt eine schematische Unteransicht bzw. Seitenansicht eins dritten erfindungsgemäßen Prozessschrittes 102, bei dem eine Vermessung der oberen, inneren Ausrichtungsmarken 6ol und 6or erfolgt. Man beachte, dass sich die obere, linke Ausrichtungsmarke 6ol in der Unteransicht der Figur 9a an der Oberseite befindet, während die untere, linke Ausrichtungsmarke 6ul in der Oberansicht der Figur 7a an der Unterseite dargestellt wird. In diesem erfindungsgemäßen Ausrichtungsschritt erfolgt eine Speicherung der Positionen der oberen, inneren Ausrichtungsmarken 6ol und 6or, sowie der Position des oberen Probenhalters 12o in der Vermessungsposition für das obere Substrat 2o.

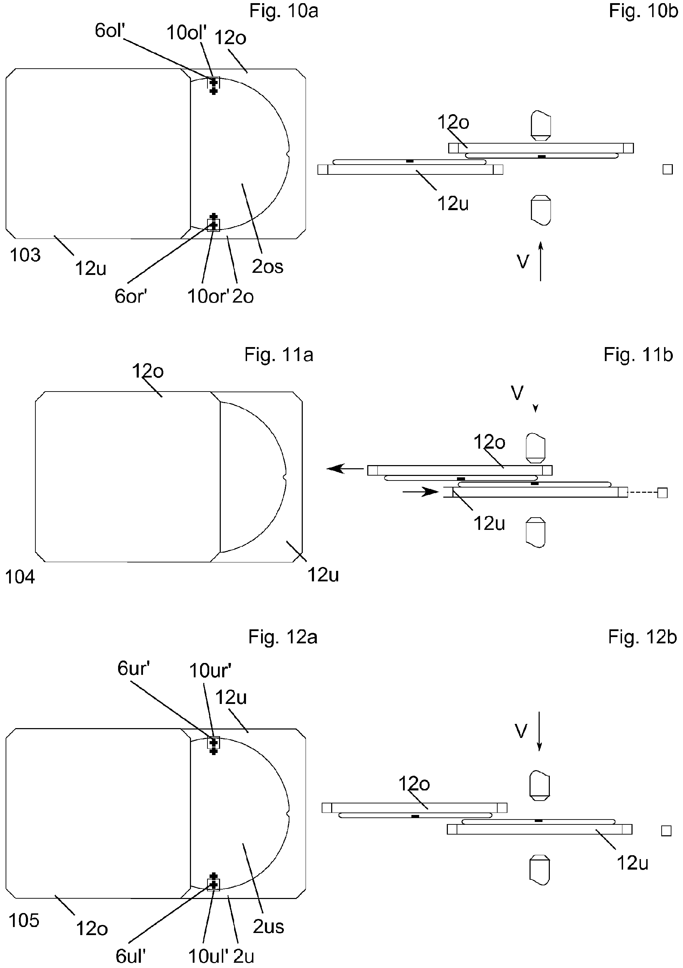

Die Figur 10a bzw. die Figur 10b zeigt eine schematische Unteransicht bzw. Seitenansicht eins vierten Prozessschrittes 103, bei dem eine Vermessung der oberen, äußeren Ausrichtungsmarken 6ol' und 6or' erfolgt. In diesem Ausrichtungsschritt erfolgt eine Speicherung der Positionen der oberen, äußeren Ausrichtungsmarken 6ol' und 6or'. Sollte die Speicherung der Position des oberen Probenhalters 12o in der Vermessungsposition für das obere Substrat 2o noch nicht erfolgt sein, kann sie in diesem Prozessschritt noch nachgeholt werden.

Die Figur 11a bzw. die Figur 11b zeigt eine schematische Oberansicht bzw. Seitenansicht eines fünften Prozessschrittes 104, bei dem ein Wechsel der Probenhalter 12o, 12u erfolgt. Der untere Probenhalter 12u wird, insbesondere mit Hilfe der Daten aus der Positionsfehlerkorrektur aus dem zweiten Prozessschritt 101, wieder in seine ursprüngliche Position verfahren. Insbesondere gleichzeitig erfolgt eine Verschiebung des oberen Probenhalters 12o in die Warteposition.

Die Figur 12a bzw. die Figur 12b zeigt eine schematische Oberansicht bzw. Seitenansicht eines sechsten Prozessschrittes 105, bei dem eine Vermessung der unteren, äußeren Ausrichtungsmarken 6ul' und 6ur' erfolgt. In diesem Ausrichtungsschritt erfolgt eine Speicherung der Positionen der unteren, äußeren Ausrichtungsmarken 6ul' und 6ur'.

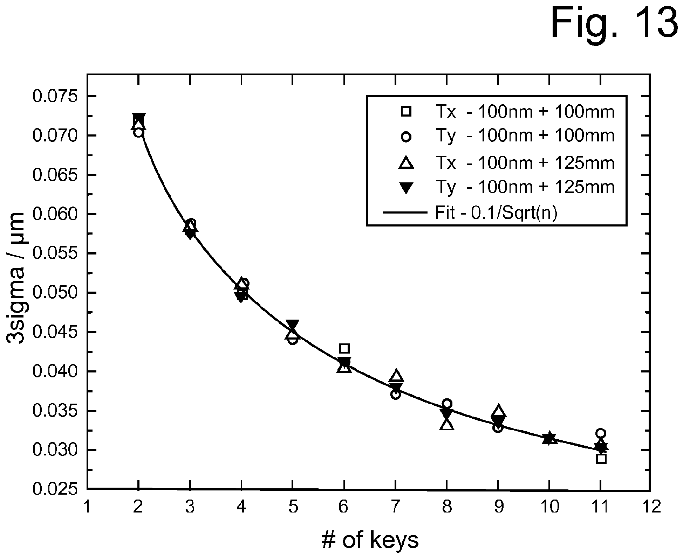

Die Figur 13 zeigt ein Diagramm, das den 3 sigma Wert des Ausrichtungsfehlers als Funktion der Anzahl vermessener Ausrichtungsmarken 6 darstellt. Mit steigender Anzahl der Ausrichtungsmarken sinkt der 3 sigma Wert des Ausrichtungsfehlers verkehrt proportional zur Wurzel der verwendeten Ausrichtungsmarken.

### Bezugszeichen

- 1,1': Substrattyp
- 2, 2', 2u, 2o: Substrat
- 2us, 2os: Substratoberfläche
- 3: Funktionale Einheit
- 4: Kerbe
- 5: Flachseite
- 6, 6i, 6', 6i`, 6l, 6l', 6r, 6r':
- 6ul, 6ul', 6ur, 6ur', 6ol, 6ol',:
- 6or, 6or': Ausrichtungsmarken
- 7i, 7, 7i', 7': zentrische Position
- 8i, 8, 8i', 8': Kanten
- 9, 9': Statistisch gemittelte Position
- 10, 10ul, 10ur, 10ol, 10or,:
- 10ul', 10ur', 10ol', 10or': Sichtbereiche
- 11ol, 11or, 11ul, 11ur: Optiken
- 12u, 12o: Probenhalter
- 13: PEC Messsystem
- rl, rl',rr, rr': Radien
- M: Ebene, insbesondere Symmetrieebene
- L1, L2, L3: Linien
- h: Schnittpunkt
- L: Linker Bereich
- R: Rechter Bereich
- Z: Zentrum
- D: Durchmesserlinie
- N: Erweiterter Kreis

## Patentansprüche

1. Verfahren zur Ausrichtung zweier zu bondender Substrate (2u, 2o), wobei das erste Substrat (2u) eine erste Substratoberfläche (2us) mit einer ersten Substratoberflächenseite und einer der ersten Substratoberflächenseite gegenüberliegenden zweiten Substratoberflächenseite aufweist, wobei das zweite Substrat (2o) eine mit der ersten Substratoberfläche (2us) zu bondende zweite Substratoberfläche (2os) aufweist, wobei die zweite Substratoberfläche (2os) eine dritte Substratoberflächenseite und eine der dritten Substratoberflächenseite gegenüberliegende vierte Substratoberflächenseite aufweist, wobei das Verfahren mindestens die folgenden Schritte aufweist:
-- Erfassung und Speicherung von ersten Positionen eines ersten Ausrichtungsmarkenpaares (6ul, 6ur) auf der ersten Substratoberfläche (2us) des ersten Substrats (2u), wobei eine erste Ausrichtungsmarke (6ul) des ersten Ausrichtungsmarkenpaares (6ul, 6ur) auf der ersten Substratoberflächenseite angeordnet ist und eine zweite Ausrichtungsmarke (6ur) des ersten Ausrichtungsmarkenpaares (6ul, 6ur) auf der zweiten Substratoberflächenseite angeordnet ist,
-- Erfassung und Speicherung von zweiten Positionen eines zweiten Ausrichtungsmarkenpaares (6ol, 6or) auf der zweiten Substratoberfläche (2os) des zweiten Substrats (2o), wobei eine dritte Ausrichtungsmarke (6ol) des zweiten Ausrichtungsmarkenpaares (6ol, 6or) auf der dritten Substratoberflächenseite angeordnet ist und eine vierte Ausrichtungsmarke (6or) des zweiten Ausrichtungsmarkenpaares (6ol, 6or) auf der vierten Substratoberflächenseite angeordnet ist,
-- Erfassung und Speicherung von dritten Positionen eines dritten Ausrichtungsmarkenpaares (6ol', 6or') auf der zweiten Substratoberfläche (2os) des zweiten Substrats (2o), wobei eine fünfte Ausrichtungsmarke (6ol') des dritten Ausrichtungsmarkenpaares (6ol', 6or') auf der dritten Substratoberflächenseite angeordnet ist und eine sechste Ausrichtungsmarke (6or') des dritten Ausrichtungsmarkenpaares (6ol', 6or') auf der vierten Substratoberflächenseite angeordnet ist,
-- Erfassung und Speicherung von vierten Positionen eines vierten Ausrichtungsmarkenpaares (6ul', 6ur') auf dem ersten Substrat (2u), wobei eine siebte Ausrichtungsmarke (6ul') des vierten Ausrichtungsmarkenpaares (6ul', 6ur') auf der ersten Substratoberflächenseite angeordnet ist und eine achte Ausrichtungsmarke (6ur') des vierten Ausrichtungsmarkenpaares (6ul', 6ur') auf der zweiten Substratoberflächenseite angeordnet ist,
-- Ausrichtung der beiden Substrate (2u, 2o) zueinander in Abhängigkeit der erfassten ersten Positionen, zweiten Positionen, dritten Positionen und vierten Positionen, wobei sich die erste Ausrichtungsmarke (6ul), die zweite Ausrichtungsmarke (6ur), die dritte Ausrichtungsmarke (6ol), die vierte Ausrichtungsmarke (6or), die fünfte Ausrichtungsmarke (6ol'), die sechste Ausrichtungsmarke (6or'), die siebte Ausrichtungsmarke (6ul') und die achte Ausrichtungsmarke (6ur') weniger als 30mm vom Rand des ersten Substrats (2u) beziehungsweise des zweiten Substrats (2o) befinden, wobei die Positionen der Ausrichtungsmarken (6ul, 6ul', 6ur, 6ur', 6ol, 6ol', 6or, 6or') optisch erfasst werden, wobei mindestens vier Optiken (11ol, 11or, 11ul, 11ur ) angeordnet werden, **dadurch gekennzeichnet, dass** sich mehrere Ausrichtungsmarken (6ul, 6ul', 6ur, 6ur', 6ol, 6ol', 6or, 6or') derselben Substratoberflächenseite gleichzeitig im Sichtbereich einer der mindestens vier Optiken (11ol, 11or, 11ul, 11ur ) befinden und vermessen werden.

2. Verfahren nach Anspruch 1,
mit folgenden Schritten, insbesondere folgendem Ablauf:
-- Anordnung und Fixierung der Substrate (2u, 2o) auf Substrathaltern (12u, 12o),
-- Bewegen des ersten Substrathalters (12u) mit dem ersten Substrat (2u) in eine erste Erfassungsposition,
-- Erfassung und Speicherung der ersten Positionen des ersten Ausrichtungsmarkenpaares (6ul, 6ur) auf der ersten Substratoberfläche (2us) des ersten Substrats (2u) in der ersten Erfassungsposition,
-- Bewegen des zweiten Substrathalters (12o) mit dem zweiten Substrat (2o) in eine zweite Erfassungsposition und Bewegung des ersten Substrathalters (12u) mit dem ersten Substrat (2u) in eine erste Warteposition,
-- Erfassung und Speicherung der zweiten Positionen des zweiten Ausrichtungsmarkenpaares (6ol, 6or) auf der zweiten Substratoberfläche (2os) des zweiten Substrats (2o) in der zweiten Erfassungsposition,
-- Erfassung und Speicherung der dritten Positionen des dritten Ausrichtungsmarkenpaares (6ol', 6or') auf der zweiten Substratoberfläche (2os) des zweiten Substrats (2o) in der zweiten Erfassungsposition des zweiten Substrathalters (12o),
-- Bewegen des ersten Substrathalters (12u) mit dem ersten Substrat (2u) in die erste Erfassungsposition und Bewegung des zweiten Substrathalters (12o) mit dem zweiten Substrat (2o) in eine zweite Warteposition,
-- Erfassung und Speicherung der vierten Positionen des vierten Ausrichtungsmarkenpaares (6ul', 6ur') auf dem ersten Substrat (2u) in der ersten Erfassungsposition,
-- Ausrichtung der beiden Substrate (2u, 2o) zueinander in Abhängigkeit der erfassten ersten Positionen, zweiten Positionen, dritten Positionen und vierten Positionen.

3. Verfahren nach einem der vorhergehenden Ansprüche, wobei auf den Substraten (2u, 2o) pro Substratoberflächenseite die Positionen von mindestens drei Ausrichtungsmarken (6ul, 6ul', 6ur, 6ur', 6ol, 6ol', 6or, 6or') erfasst werden, bevorzugt von mindestens vier Ausrichtungsmarken (6ul, 6ul', 6ur, 6ur', 6ol, 6ol', 6or, 6or'), noch bevorzugter von mindestens fünf Ausrichtungsmarken (6ul, 6ul', 6ur, 6ur', 6ol, 6ol', 6or, 6or'), am bevorzugtesten von mindestens sechs Ausrichtungsmarken (6ul, 6ul', 6ur, 6ur', 6ol, 6ol', 6or, 6or').

4. Verfahren nach einem der vorhergehenden Ansprüche, wobei die Ausrichtungsmarken (6ul, 6ul', 6ur, 6ur', 6ol, 6ol', 6or, 6or') einer Substratoberflächenseite innerhalb eines Kreises K mit einem Radius kleiner als 100 mm angeordnet sind, vorzugsweise kleiner als 50 mm, noch bevorzugter kleiner als 25mm, am bevorzugtesten kleiner als 10 mm, am allerbevorzugtesten kleiner als 1mm.

5. Verfahren nach einem der vorhergehenden Ansprüche, wobei die Positionen der Substrathalter (12u, 12o) durch Interferometer und/oder Optiken erfasst werden, die insbesondere von Erfassungseinrichtungen zur Erfassung der Positionen der Ausrichtungsmarken (6ul, 6ul', 6ur, 6ur', 6ol, 6ol', 6or, 6or') unabhängig sind.

6. Verfahren nach einem der vorhergehenden Ansprüche, wobei die Substrathalter (12o, 12u) in den Erfassungspositionen fixiert werden.

## Claims

1. A method for aligning two substrates (2u, 2o) to be bonded, wherein the first substrate (2u) has a first substrate surface (2us) with a first substrate surface side and a second substrate surface side lying opposite the first substrate surface side, wherein the second substrate (2o) has a second substrate surface (2os) to be bonded to the first substrate surface (2us), wherein the second substrate surface (2os) has a third substrate surface side and a fourth substrate surface side lying opposite the third substrate surface side, wherein the method comprises at least the following steps:
-- detection and storage of first positions of a first alignment mark pair (6ul, 6ur) on the first substrate surface (2us) of the first substrate (2u), wherein a first alignment mark (6ul) of the first alignment mark pair (6ul, 6ur) is arranged on the first substrate surface side and a second alignment mark (6ur) of the first alignment mark pair (6ul,6ur) is arranged on the second substrate surface side,
-- acquisition and storage of second positions of a second alignment mark pair (6ol, 6or) on the second substrate surface (2os) of the second substrate (2o), wherein a third alignment mark (6ol) of the second alignment mark pair (6ol, 6or) is arranged on the third substrate surface side and a fourth alignment mark (6or) of the second alignment mark pair (6ol, 6or) is arranged on the fourth substrate surface side,
-- detection and storage of third positions of a third alignment mark pair (6ol', 6or') on the second substrate surface (2os) of the second substrate (2o), wherein a fifth alignment mark (6ol') of the third alignment mark pair (6ol, 6or) is arranged on the third substrate surface side and a sixth alignment mark (6or') of the third alignment mark pair (6ol', 6or') is arranged on the fourth substrate surface side,
-- detection and storage of fourth positions of a fourth alignment mark pair (6ul', 6ur') on the first substrate (2u), wherein a seventh alignment mark (6ul') of the fourth alignment mark pair (6ul', 6ur') is arranged on the first substrate surface side and an eighth alignment mark (6ur') of the fourth alignment mark pair (6ul', 6ur') is arranged on the second substrate surface side,
-- alignment of the two substrates (2u, 2o) with one another depending on the detected first positions, second positions, third positions and fourth positions, wherein the first alignment mark (6ul), the second alignment mark (6ur), the third alignment mark (6ol), the fourth alignment mark (6or), the fifth alignment mark (6ol'), the sixth alignment mark (6or'), the seventh alignment mark (6ul') and the eighth alignment mark (6ur') are less than 30 mm from the edge of the first substrate (2u) or the second substrate (2o), wherein the positions of the alignment marks (6ul, 6ul', 6ur, 6ur', 6ol, 6ol', 6or, 6or') are optically detected, wherein at least four optics (11ol, 11or, 11ul, 11ur ) are arranged, **characterised in that** a plurality of alignment marks (6ul, 6ul', 6ur, 6ur', 6ol, 6ol', 6or, 6or') of the same substrate surface side are simultaneously present and measured in the field of vision of one of the at least four optics (11ol, 11or, 11ul, 11ur ).

2. The method according to claim 1, with the following steps, in particular in the following sequence:
-- arrangement and fixing of the substrates (2u, 2o) on substrate holders (12u, 12o),
-- movement of the first substrate holder (12u) with the first substrate (2u) into a first detection position,
-- detection and storage of the first positions of the first alignment mark pair (6ul, 6ur) on the first substrate surface (2us) of the first substrate (2u) in the first detection position,
-- movement of the second substrate holder (12o) with the second substrate (2o) into a second detection position and movement of the first substrate holder (12u) with the first substrate (2u) into a first waiting position,
-- detection and storage of the second positions of the second alignment mark pair (6ol, 6or) on the second substrate surface (2os) of the second substrate (2o) in the second detection position,
-- detection and storage of the third positions of the third alignment mark pair (6ol', 6or') on the second substrate surface (2os) of the second substrate (2o) in the second detection position of the second substrate holder (12o),
-- movement the first substrate holder (12u) with the first substrate (2u) into the first detection position and movement of the second substrate holder (12o) with the second substrate (2o) into a second waiting position,
-- detection and storage of the fourth positions of the fourth alignment mark pair (6ul', 6ur') on the first substrate (2u) in the first detection position,
-- alignment of the two substrates (2u, 2o) with each other depending on the detected first positions, second positions, third positions and fourth positions.

3. The method according to any one of the preceding claims, wherein the positions of at least three alignment marks (6ul, 6ul', 6ur, 6ur', 6ol, 6ol', 6or, 6or'), preferably of at least four alignment marks (6ul, 6ul', 6ur, 6ur', 6ol, 6ol', 6or, 6or'), even more preferably of at least five alignment mark (6ul, 6ul', 6ur, 6ur', 6ol, 6ol', 6or, 6or'), most preferably of at least six alignment marks (6ul, 6ul', 6ur, 6ur', 6ol, 6ol', 6or, 6or') are detected on the substrates (2u, 2o) per substrate surface side.

4. The method according to any of the preceding claims, wherein the alignment marks (6ul, 6ul', 6ur, 6ur', 6ol, 6ol', 6or, 6or') of a substrate surface side are arranged inside a circle K with a radius less than 100 mm, preferably less than 50 mm, more preferably less than 25 mm, most preferably less than 10 mm, with utmost preference less than 1 mm.

5. The method according to any of the preceding claims, wherein the positions of the substrate holders (12u, 12o) are detected by interferometers and/or optics, which in particular are independent of detection devices for the detection of the positions of the alignment marks (6ul, 6ul', 6ur, 6ur', 6ol, 6ol', 6or, 6or').

6. The method according to any one of the preceding claims, wherein the substrate holders (12o, 12u) are fixed in the detection positions.

## Revendications

1. Procédé d'alignement de deux substrats à lier (2u, 2o), le premier substrat (2u) présentant une première surface de substrat (2us) avec un premier côté de surface de substrat et un deuxième côté de surface de substrat opposé au premier côté de surface de substrat, le second substrat (2o) ayant une seconde surface de substrat (2us) à lier à la première surface de substrat (2os), la deuxième surface de substrat (2os) comportant troisième côté de surface du substrat et un quatrième côté de surface de substrat opposé au troisième côté de surface du substrat, le procédé présentant au moins les étapes suivantes :
-- détection et stockage des premières positions d'une première paire de marques d'alignement (6ul, 6ur) sur la première surface de substrat (2us) du premier substrat (2u), avec une première marque d'alignement (6ul) de la première paire de marques d'alignement (6ul, 6ur) étant disposée sur le premier côté de surface de substrat et une deuxième marque d'alignement (6ur) de la première paire de marques d'alignement (6ul, 6ur) étant disposée sur le deuxième côté de surface du substrat,
-- détection et stockage de deuxièmes positions d'une deuxième paire de marques d'alignement (6ol, 6or) sur la deuxième surface de substrat (2os) du second substrat (2o), une troisième marque d'alignement (6ol) de la deuxième paire de marques d'alignement (6ol, 6or) étant disposée sur le troisième côté de surface de substrat et une quatrième marque d'alignement (6or) de la deuxième paire de marques d'alignement (6ol, 6or) étant disposée sur le quatrième côté de surface du substrat,
-- détection et stockage de troisièmes positions d'une troisième paire de marques d'alignement (6ol', 6or') sur la deuxième surface de substrat (2os) du second substrat (2o), avec une cinquième marque d'alignement (6ol') de la troisième paire de marques d'alignement (6ol', 6or') étant disposée sur le troisième côté de surface de substrat et une sixième marque d'alignement (6or') de la troisième paire de marques d'alignement (6ol', 6or') étant disposée sur le quatrième côté de surface du substrat,
-- détection et stockage de quatrième positions d'une quatrième paire de marques d'alignement (6ul', 6ur') sur le premier substrat (2u), une septième marque d'alignement (6ul') de la quatrième paire de marques d'alignement (6ul', 6ur') étant disposée sur le premier côté de de surface du substrat et une huitième marque d'alignement (6ur') de la quatrième paire de marques d'alignement (6ul', 6ur') étant disposée sur le deuxième côté de surface du substrat,
-- alignement des deux substrats (2u, 2o) en fonction des premières positions, des deuxièmes positions, des troisièmes et des quatrièmes positions enregistrées, la première marque d'alignement (6ul), la deuxième marque d'alignement (6ur), la troisième marque d'alignement (6ol), la quatrième marque d'alignement (6or), la cinquième marque d'alignement (6ol'), la sixième marque d'alignement (6or') la septième marque d'alignement (6ul') et la huitième marque d'alignement (6ur') étant situées à moins de 30 mm du bord du premier substrat (2u) ou du second substrat (2o),les positions des marques d'alignement (6ul, 6ul', 6ur, 6ur', 6ol, 6ol', 6or, 6or') étant détectées visuellement, avec au moins quatre optiques (11ol, 11or, 11ul, 11ur), **caractérisé en ce que** plusieurs marques d'alignement (6ul, 6ul', 6ur, 6ur', 6ol, 6ol', 6or, 6or') du même côté de surface de substrat se trouvent et sont mesurées simultanément dans la zone de vision de l'une des au moins quatre optiques (11ol, 11or, 11ul, 11ur).

2. Procédé selon la revendication 1, comprenant les étapes suivantes, notamment :
-- disposition et fixation des substrats (2u, 2o) sur des supports de substrat (12u, 12o),
-- déplacement du premier support de substrat (12u) avec le premier substrat (2u) dans une première position de détection,
-- détection et stockage des premières positions de la première paire de marques d'alignement (6ul, 6ur) sur la première surface de substrat (2us) du premier substrat (2u) dans la première position de détection,
-- déplacement du second support de substrat (12o) avec le second substrat (2o) dans une deuxième position de détection et déplacement du premier support de substrat (12u) avec le premier substrat (2u) dans une première position d'attente,
-- détection et stockage des deuxièmes positions de la deuxième paire de marques d'alignement (6ol, 6or) sur la deuxième surface de substrat (2os) du second substrat (2o) dans la deuxième position de détection,
-- détection et stockage des troisième positions de la troisième paire de marques d'alignement (6ol', 6or') sur la deuxième surface de substrat (2os) du second substrat (2o) dans la deuxième position de détection du second support de substrat (12o),
-- déplacement du premier support de substrat (12u) avec le premier substrat (2u) vers la première position de détection et déplacement du second support de substrat (12o) avec le second substrat (2o) vers une deuxième position d'attente,
-- détection et stockage des quatrièmes positions de la quatrième paire de marques d'alignement (6ul', 6ur') sur le premier substrat (2u) dans la première position de détection,
-- alignement des deux substrats (2u, 2o) l'un par rapport à l'autre en fonction des premières positions, des deuxièmes positions, des troisièmes positions et des quatrième positions enregistrées.

3. Procédé selon l'une des revendications précédentes, dans lequel, sur les substrats (2u, 2o) par côté de surface du substrat, les positions d'au moins trois marques d'alignement (6ul, 6ul', 6ur, 6ur', 6ol, 6ol', 6or, 6or'), de préférence d'au moins quatre marques d'alignement (6ul, 6ul', 6ur, 6ur', 6ol, 6ol', 6or, 6or'), de manière encore plus préférentielle d'au moins cinq marques d'alignement (6ul, 6ul', 6ur, 6ur', 6ol, 6ol', 6or, 6or'), de manière la plus préférentielle d'au moins six marques d'alignement (6ul, 6ul', 6ur, 6ur', 6ol, 6ol', 6or, 6or'), sont enregistrées.

4. Procédé selon l'une des revendications précédentes, dans lequel les marques d'alignement (6ul, 6ul', 6ur, 6ur', 6ol, 6ol', 6or, 6or') d'un côté de surface de substrat sont disposées à l'intérieur d'un cercle K d'un rayon inférieur à 100 mm, de préférence inférieur à 50 mm, de manière plus préférentielle inférieur à 25 mm, de manière encore plus préférentielle inférieur à 10 mm, de manière extrêmement préférentielle inférieur à 1 mm.

5. Procédé selon l'une des revendications précédentes, dans lequel les positions des supports de substrat (12u, 12o) sont enregistrées par des interféromètres et/ou des optiques qui sont notamment indépendants de dispositifs de détection destinés à enregistrer les positions des marques d'alignement (6ul, 6ul', 6ur, 6ur', 6ol, 6ol', 6or, 6or').

6. Procédé selon l'une des revendications précédentes, dans lequel les supports de substrat (12o, 12u) sont fixés dans les positions d'enregistrement.
